**Europäisches Patentamt**

**European Patent Office**

**Office européen des brevets**

(19)

(11) Publication number: **0 383 391**
**A1**

# EUROPEAN PATENT APPLICATION

(12)

(21) Application number: **90200310.2**

(22) Date of filing: **12.02.90**

(51) Int. Cl.⁵: **H01L 21/20, H01L 21/58**

---

The title of the invention has been amended (Guidelines for Examination in the EPO, A-III, 7.3).

(30) Priority: **17.02.89 NL 8900388**

(43) Date of publication of application:
**22.08.90 Bulletin 90/34**

(84) Designated Contracting States:
**DE FR GB NL**

(71) Applicant: **N.V. Philips' Gloeilampenfabrieken**
**Groenewoudseweg 1**
**NL-5621 BA Eindhoven(NL)**

(72) Inventor: **Bouwer, Adrianus Gerardus**
**INT. OCTROOIBUREAU B.V, Prof. Holstlaan 6**
**NL-5656 Eindhoven(NL)**
Inventor: **Hagen, Johannes Ludovicus**
**INT. OCTROOIBUREAU B.V, Prof. Holstlaan 6**
**NL-5656 Eindhoven(NL)**
Inventor: **Haisma, Jan**
**INT. OCTROOIBUREAU B.V, Prof. Holstlaan 6**
**NL-5656 Eindhoven(NL)**
Inventor: **Walraven, Wilhelmus Martinus**
**INT. OCTROOIBUREAU B.V, Prof. Holstlaan 6**
**NL-5656 Eindhoven(NL)**

(74) Representative: **Gorter, Willem Karel et al**
**INTERNATIONAAL OCTROOIBUREAU B.V.**
**Prof. Holstlaan 6**
**NL-5656 AA Eindhoven(NL)**

---

(54) **Method of connecting two objects together, for example a slice of an insulating material to a slice of a semiconductor material.**

(57) A method of connecting two objects, such as for example a slice (1) of an insulating material and a slice (2) of a monocrystalline semiconductor material as employed in semiconductor technology, the objects being provided with complementary optically smooth surfaces (3, 4) and being subsequently brought into contact with each other with the optically smooth surfaces, causing atomic bonds to be formed between atoms of the two objects. After the objects have been provided with optically smooth surfaces the objects are locally brought into contact with each other in a position in which the optically smooth surfaces occupy a non-parallel position relative to each other, after which the objects are moved relative to each other until the optically smooth surfaces contact each other in a final parallel position.

FIG.6

## Method of connecting two objects

The invention relates to a method of connecting two objects, such as for example a slice of an insulating material and a slice of a monocrystalline semiconductor material as employed in semiconductor technology, the objects being provided with complementary optically smooth surfaces and being subsequently brought into contact with each other with the optically smooth surfaces, causing atomic bonds to be formed between atoms of the two objects.

Such an atomic bond is also referred to as a van der Waals' bond.

A method of the above type is known, for example from EP-A 209,173. For this method it is necessary to subject the surfaces of the two objects to an additional bond-activating process and, in addition, it is not unlikely that, at least locally, the bond is imperfect as a result of the inclusion of extraneous matter, for example entrapment of an air bubble.

It is an object of the invention to simplify the method, to optimize control of the method and to improve the bond, and to this end the invention is characterized in that after the objects have been provided with optically smooth surfaces the objects are locally brought into contact with each other in a position in which the optically smooth surfaces occupy a non-parallel position relative to each other, after which the objects are moved relative to each other until the optically smooth surfaces contact each other in a final parallel position.

Special embodiments of the methods and arrangements for carrying out such methods are defined the subsidiary Claims.

The invention will now be explained by means of a description, with reference to the Figures, of some methods in accordance with the invention and a description of an arrangement, shown in the Figures, for carrying out one of these methods.

Figure 1 is a perspective view of the two objects to be interconnected.

Figure 2 shows the objects after they have been interconnected.

Figures 3 to 5 show three stages of a first method in accordance with the invention.

Figures 6 to 8 illustrate a second method.

Figures 9 and 10 illustrate a third method.

Figures 11 to 13 relate to the same method as illustrated in Figures 9 and 10 but applied to different objects.

Figure 14 is a perspective view of an arrangement for carrying out the third method.

Figure 15 is a side view of the arrangement shown in Figure 14.

Figure 16 is a plan view of the arrangement shown in Figure 14.

Figure 17 is a front view of the arrangement shown in Figure 14.

Figures 18 to 20 show a part of the arrangements in Figures 14 to 17 to an enlarged scale in different stages of the method.

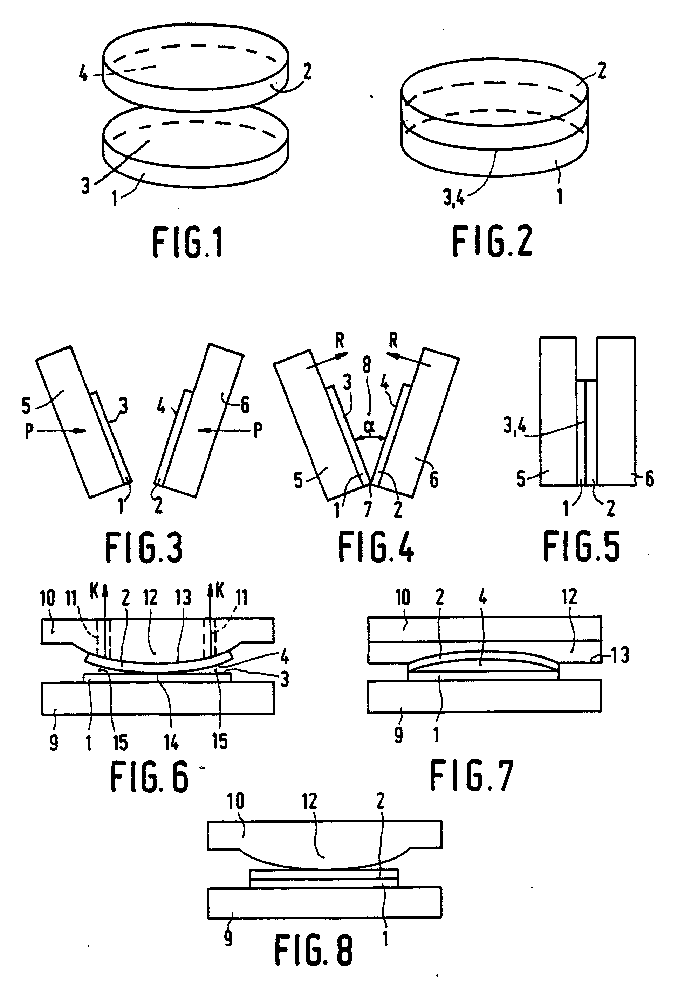

The objects to be interconnected, as shown in Figure 1, are a slice 1 of, for example, amorphous silicon and a slice 2 of monocrystalline silicon. At their facing sides these slices are provided with optically polished flat surfaces 3 and 4 respectively. If these slices 1 and 2 are brought into contact with each other with their surfaces 3 and 4 (Figure 2) bonding forces of an electrical dipole nature (the said van der Waals' forces) may arise between an atom in the contact surface 3 and an atom in the contact surface 4 if the contact surfaces 3 and 4 are satisfactorily smooth and no inclusions are present between these surfaces. This enables a satisfactory adhesion between the two slices 1 and 2 to be obtained without a separate connecting material between the two slices being needed. This is important in particular if the interconnected slices are to be employed in semiconductor technology, for example for the fabrication of two-dimensional or three-dimensional ICs, because the presence of extraneous matter in the silicon may adversely affect the properties thereof.

In accordance with the methods illustrated in Figures 3 to 5 the slices 1 and 2 are placed on the supports 5 and 6 respectively and are positioned relative to each other. The polished surfaces 3 and 4 the face each other. The supports 5 and 6 are moved towards each other in the direction indicated by the arrow P until the slices contact each other in point 7 (Figure 4). The optically smooth surfaces 3 and 4 are then in a non-parallel position relative to each other and are inclined at, for example, an acute angle. Subsequently, the supports 5 and 6 are rotated in the directions R about point 7, so that the smooth polished surfaces 3 and 4 approach one another. The gas, for example air, present in the wedgelike space 8 is then forced away until there is no or hardly any extraneous matter between the slices 1 and 2 when the two slices are wholly in contact with each other (Figure 5). Instead of in an air atmosphere the process may also be carried out in an environment with another gas. Hydrogen is a suitable gas atmosphere because already from a temperature of 500°C any residual entrapped hydrogen atoms readily diffuse into the monocrystalline silicon and can no longer impair the bond between the objects.

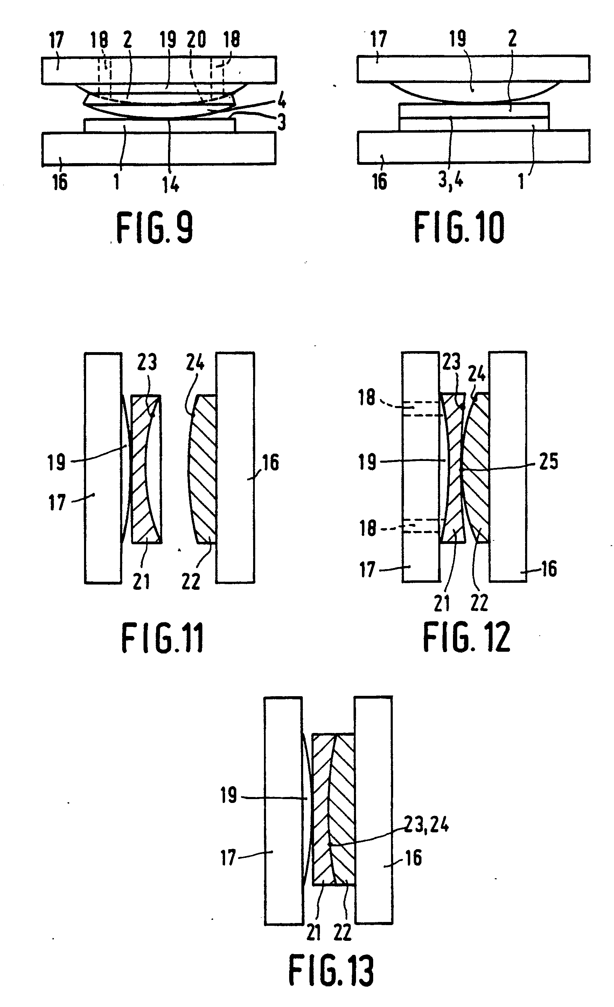

In the method as illustrated in Figures 6 to 8 the slices 1 and 2 are also placed on supports 9 and 10 respectively. By exerting forces K on the slice 2 this slice can be elastically deformed to some extent so as to give the smooth polished surface 4 a convex curvature. These forces K van be obtained, for example, by creating a partial vacuum in the ducts 11 of the support 10 so that the slice 2 is pressed against the portion 12 of the support 10. The surface 13 of the portion 12 is shaped as a cylindrical surface so that the slice 2 also assumes this shape. The smooth surface 4 of the slice 2 is also shaped cylindrically. In the same way as in the method illustrated in Figures 3 to 5 the slices 1 and 2 are positioned relative to each other and moved towards each other. In the situation illustrated in Figure 6 the slice 1 contacts the slice 2 at the location 14, the optically smooth surfaces 3 and 4 occupying a non-parallel position relative to each other. Figure 7 shows this situation in a side view. When the partial vacuum in the channels 11 is cancelled the slice 2 can resume its original flat shape and the surfaces 3 and 5 come wholly in contact with each other (Figure 8). This causes air and/or other extraneous matter to be expelled from the centre 14 out of the wedge-shaped spaces 15 (Figure 6), enabling a correct bond between the two slices 1 and 2 to be obtained.

In the method as illustrated in Figures 9 and 10 the slices 1 and 2 are again placed on the supports 16 and 17 respectively. In the same way as in the method illustrated in Figures 6 to 8 the slice 2 is pressed against the portion 19 of the support 17 by a partial vacuum in the ducts 18. However, the portion 19 has a surface 20 which is curved as a segment of a spherical surface so that the smooth polished surface 4 of the slice 2 also assumes such a convex shape. Figure 10 shows the supports 16 and 17 and the slices 1 and 2 in a side view similar to that in Figure 9 after the partial vacuum has been cancelled, causing the slice 2 to resume its original flat shape and the slices 1 and 2 to become attached to each other.

In the methods described above with reference to Figures 3 to 10 the objects 1 and 2 to be interconnected have flat polished surfaces 3 and 4. However, the method may also be applied to objects having polished surfaces of complementary curvature such as, for example, the objects 21 and 22, which are shown in cross-section in Figures 11 to 13. These objects 21 and 22 have polished surfaces 23 and 24 respectively curved as segments of spherical surfaces, the surface 23 being concave and the surface 24 being convex. The method is identical to that described with reference to Figures 9 and 10, the supports 16 and 17 being also the same. Figure 12 illustrates the situation in which the object 21 is pressed against the portion 19 by the partial vacuum in the ducts 18, causing the object 21 to be deformed elastically and the objects 21 and 22 to contact each other only locally in 25.

Subsequently, by cancelling the partial vacuum, the object can relax and resume its original shape as shown in Figure 11. As a result of this, the surfaces 23 and 24 will come wholly in contact with each other to form the bond between the objects 21 and 22.

Obviously, the method may also be applied to objects having complementary, i.e. interengaging, surfaces curved in another way than surfaces of spherical segments.

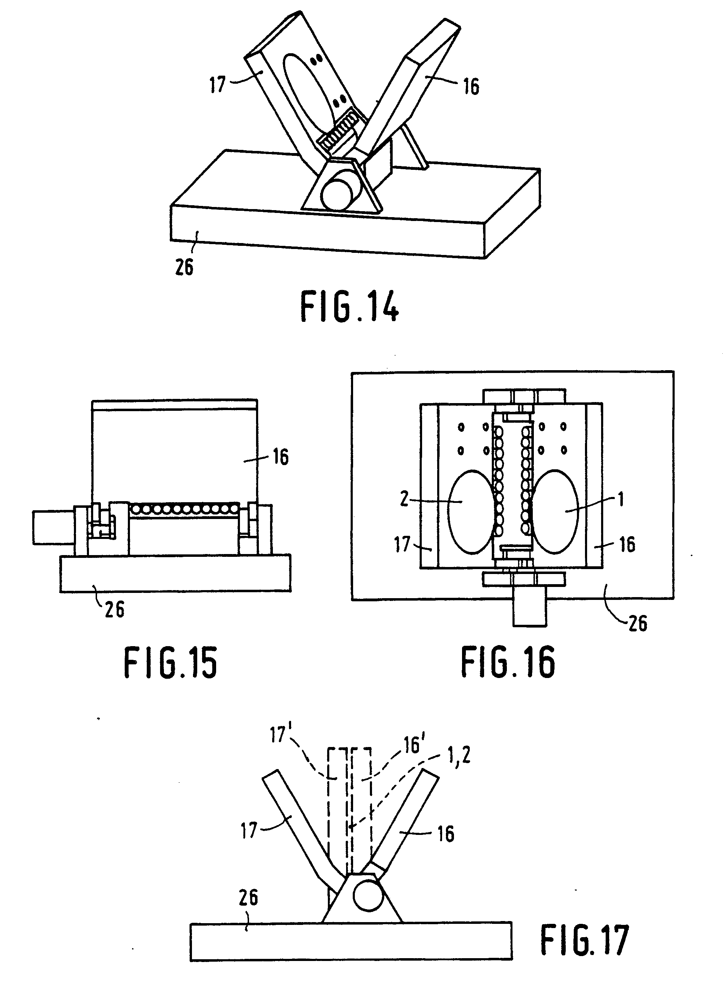

The arrangement as shown in Figures 14 to 20 can be employed, for example, for carrying out the method shown in Figures 9 and 10. The arrangement comprises the two supports 16 and 17, which are pivotally mounted on a base 26. As is shown in the plan view of Figure 16, each of the supports carries a slice 1 and 2 respectively. By tilting the supports they can be brought in a position in which the slices 1 and 2 are in contact with each other, as indicated in broken lines in Figure 17. In the open position shown in Figure 14 the supports 16 and 17 are retained by stops, not shown, on the base 26.

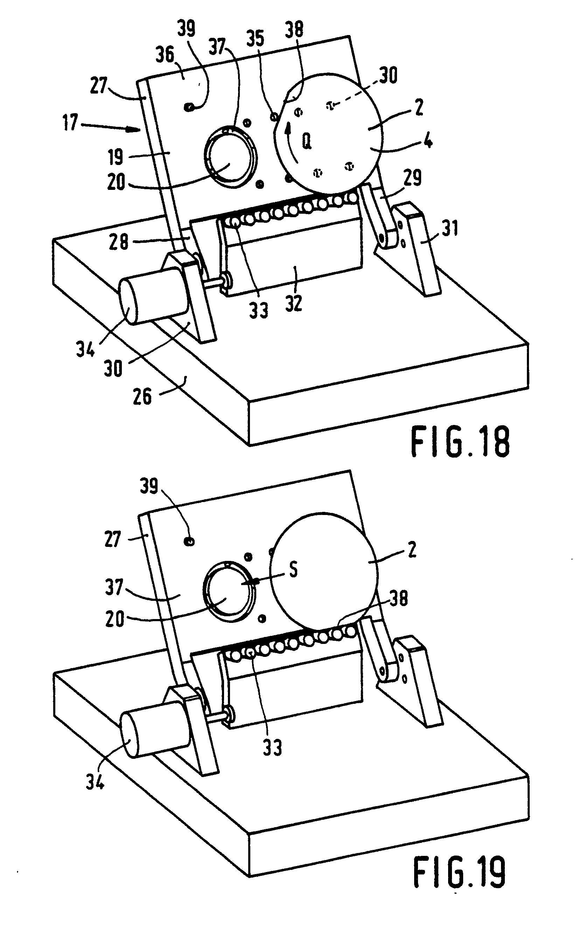

For the sake of clarity the support 16 is not shown in Figures 18 to 20. However, this support 16 can be of a construction similar to that of the support 17. The support 17 comprises a supporting portion 27 and limbs 28 and 29 by which the support is pivotally mounted in the lugs 30 and 31 of the base 26. The base 26 also has a wall portion 32 between the limbs 28 and 29. This wall portion 32 is provided with rotation and translation mechanisms in the form of rollers 33, which can be rotated in a manner known per se by an electric motor 34. The ducts 18 (Figure 9) terminate in apertures 35 in the surface 36 of the supporting portion 27 of the support 17. These ducts may be connected to the suction or pressure side of a gas-dis placement device. Moreover, the supporting portion 27 is formed with an annular groove 37 which can also be connected to this air-displacement system. This annular groove 37 is situated at the location of the supporting portion 19 having the spherical surface 20.

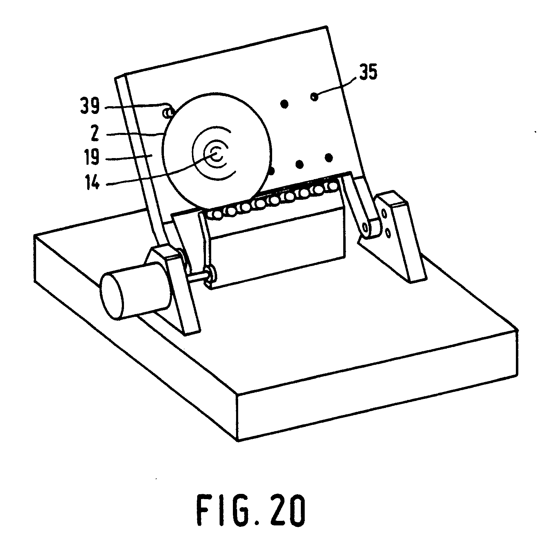

The device operates as follows. A slice 2 is placed on the rollers 33, for example by means of a vacuum chuck (Figure 18). The chuck acts on the back of the slice so that the slice is not wholly in contact with the supporting portion 27 but projects slightly. By connecting the ducts to the pressure side of the gas-displacement device a gas layer is obtained between the surface 36 and the slice 2 so that the support 17 supports the slice substantially without any friction in the so-called set-up position. Since the rollers 33 are rotated by motor 34 the

slice 2 is also rotated in the direction indicated by the arrow Q. The slice 2 is rotated until a truncated side 38 of the slice is in contact with the rollers 33 (Figure 19). Subsequently, the rollers 33 are rotated to move the slice 2 in the direction S until the slice lies against the stop 39 (Figure 20). The slice 2 is now situated at the location of the supporting portion 19 with the annular groove 37 in the so-called operating position. If this annular groove 37 is connected to the suction side of the gas-displacement device the slice 2 is drawn against the spherical surface 20 of the portion 19 and the situation as illustrated in Figure 9 is obtained. The slice 1 is positioned and held on the support 16 in a similar way, but this support does not have a supporting portion 19 with a spherical surface so that the slice 1 retains its original straight shape (see also Figure 9). Now the slices 1 and 2 are in an accurately defined position relative to each other. By pivoting the supports 16 and 17 towards one another the slices 1 and 2 can be brought into contact with each other (Figure 9), the contact being local, i.e. at a central location 14, as a result of the convex shape of the polished surface 4 of the slice 2. When the connection between the groove 37 and the air-displacement device is interrupted the slice 2 can resume its original straight shape (Figure 10), so that a "wringing" effect occurs and the slices 1 and 2 are firmly attached to each other.

Obviously, it is also possible to mount only one of the supports 16, 17 pivotably on the base 26, the other support being fixedly mounted.

## Claims

1. A method of connecting two objects, such as for example a slice of an insulating material and a slice of a monocrystalline semiconductor material as employed in semiconductor technology, the objects being provided with complementary optically smooth surfaces and being subsequently brought into contact with each other with the optically smooth surfaces, causing atomic bonds to be formed between atoms of the two objects, characterized in that after the objects have been provided with optically smooth surfaces the objects are locally brought into contact with each other in a position in which the optically smooth surfaces occupy a non-parallel position relative to each other, after which the objects are moved relative to each other until the optically smooth surfaces contact each other in a final parallel position.

2. A method as claimed in Claim 1, characterized in that at least one of the objects is subjected to forces by which the optically smooth surface of said object is slightly deformed, after which the objects are brought locally into contact with each other and subsequently the deformation is cancelled.

3. A method as claimed in Claim 2, for connecting two objects having straight optically smooth surfaces, characterized in that the optically smooth surface is curved in accordance with a cylindrical surface.

4. A method as claimed in Claim 2, for connecting two objects having straight optically smooth surfaces, characterized in that the optically smooth surface is given a convex curvature in accordance with a segment of a spherical surface.

5. A method as claimed in Claim 2, 3 or 4, characterized in that at least one of the objects is placed on a support having gas ducts and said object is subjected to forces by creating a partial vacuum in said ducts.

6. A method as claimed in Claim 5, characterized in that the gas is hydrogen.

7. An arrangement for carrying out a method as claimed in any one of the preceding Claims, characterized in that the arrangement comprises a support for each of the objects, at least one of the supports being movable relative to the other and the supports being provided with positioning elements for the objects.

8. An arrangement as claimed in Claim 7, characterized in that each support has a supporting surface for the object, the gas ducts terminating in the supporting surface and being connected to a gas-displacement device for influencing the gas pressure prevailing between the supporting surface and the object.

9. An arrangement as claimed in Claim 7 or 8, characterized in that a support has a set-up position and an operating position for the object and is provided with rotation and translation mechanisms for movement between the two positions, the operating position being defined by the positioning elements.

10. An arrangement as claimed in Claim 8, characterized in that the support has a convex supporting surface for the object.

FIG.1

FIG.2

FIG.3

FIG.4

FIG.5

FIG.6

FIG.7

FIG.8

FIG.9

FIG.10

FIG.11

FIG. 12

FIG.13

FIG.14

FIG.15

FIG.16

FIG.17

FIG.18

FIG.19

FIG. 20

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| D,A | EP-A-0 161 740 (TOSHIBA) | | H 01 L 21/20 |
| A | EP-A-0 232 935 (PHILIPS) | | H 01 L 21/58 |
| D,A | EP-A-0 209 173 (PHILIPS) | | |
| A | US-A-4 774 196 (SILICONIX) | | |
| A | GB-A-2 056 766 (FUJITSU) | | |

TECHNICAL FIELDS SEARCHED (Int. Cl.5)

H 01 L

The present search report has been drawn up for all claims

| Place of search | Date of completion of the search | Examiner |
|---|---|---|
| THE HAGUE | 03-04-1990 | DE RAEVE R.A.L. |